# EUROPEAN PATENT APPLICATION

(11) **EP 4 167 416 A1**
(43) Date of publication of application: **19.04.2023**
(21) Application number: 21202330.3
(22) Date of filing: 13.10.2021
(51) Int. Cl.: H02J 1/10, H02J 7/35, H05K 7/20

(54) **RENEWABLE ENERGY BASED COMPUTING SYSTEM**

(71) Applicant: Siemens Gamesa Renewable Energy A/S, 7330 Brande (DK)
(72) Inventor: The designation of the inventor has not yet been filed
(74) Representative: SGRE-Association

(57) **Abstract**

There is provided a system (100) and a method of using the system for computing and storing data, the system (100) comprising a renewable energy based direct current (DC) generation unit (110) configured for outputting DC, a DC consumer (120), configured for computing and storing data and for being powered by DC, and a DC power circuit (E); wherein the DC generation unit (110) and the DC consumer (120) are directly electrically connected with each other via the DC power circuit (E).

## Description

### Field of Invention

The present invention relates to a system and a method of using the system for computing and storing data, the system being based on renewable energy.

### Art Background

Due to ever growing digitalization, in recent years, the demand for electric power, in particular for powering computing devices, has grown steadily. Conventionally, electric power is produced by a generation unit such as a power plant, either based on fossil fuels or on regenerative energies. The electric power is then converted and transformed multiple times, for example from an alternating current (AC) to a direct current (DC), or from one voltage level to a different voltage level. Usually, the electric power also has to be transported over long distances, for example via long distance, high voltage power lines. Both factors -conversion and transport- significantly contribute to high losses of useable electric energy. On the other hand, there has also been a growing demand for electric power based on renewable energies. Among others, wind power, in particular offshore wind power, is considered a good alternative to conventional power sources.

Therefore, there may be a need to provide a renewable energy based electric power source with reduced loss of useable energy.

### Summary of the invention

This need may be met by the subject matter according to the independent claims. Advantageous embodiments of the present invention are described by the dependent claims.

According to a first aspect of the invention, there is provided a system comprising a renewable energy based direct current (DC) generation unit configured for outputting DC, a DC consumer, configured for computing and storing data and for being powered by DC, and a DC power circuit. The DC generation unit and the DC consumer may be directly electrically connected with each other via the DC power circuit.

According to a further aspect of the invention there is provided a server farm, comprising a plurality of systems according to embodiments of the present disclosure.

According to a further aspect of the invention there is provided a method of using a system according to embodiments of the present disclosure, for computing and/or storing data.

In the context of the present document, the term "renewable energy" may particularly denote useable energy that is collected from or present in renewable resources, which are naturally replenished on a human timescale, including carbon neutral sources like sunlight, wind, rain, tides, waves, and geothermal heat, amongst others. This type of energy source stands in contrast to fossil fuels.

In the context of the present document, the term "direct current (DC) generation unit" may particularly denote any unit comprising a device configured for converting energy stored in a renewable resource into electric energy, wherein the electric energy is output in the form of a DC current, preferably without any conversion steps between. For example, a DC generation unit may comprise solar panels or a wind driven generator, configured for converting energy stored in the sunlight or in the wind, respectively, into electricity.

In the context of the present document, the term "DC consumer" may particularly denote any device which is configured for being powered by DC (e.g., 2V, 5V, 12V, etc.), such as a computer device for cloud computing, cloud storage, cloud communications and similar applications.

In the context of the present document, the term "directly electrically connected" may particularly denote an electric connection which does not include and is therefore free of any (DC to AC and/or AC to DC) conversion stages. In this context, "alternating current (AC)" may particularly denote sinusoidal and/or sinusoidal-similar AC and may include industry standards for AC at e.g., 16.67 Hertz (Hz), 50 Hz, 60 Hz, etc. It may in particular not include AC, if DC switches from e.g. -5V to 5V in a non-sinusoidal pattern.

In the context of the present document, the term "server farm" may particularly denote a group of similar, networked (electrically connected and/or data linked) systems that are connected to form one superordinate logical system for improving the utilization of resources and increasing the availability, performance, and security of applications.

According to an exemplary embodiment, the present invention may be based on the idea that a renewable energy based electric power source with reduced loss of useable energy may be provided, when a renewable energy based DC generating unit and DC consumer are directly electrically connected to each other.

Conventionally, energy is transferred via a public grid operating on AC to a place of consumption. DC to AC and AC to DC conversion, as well as transmission in subsea cables or landlines, is connected to extreme losses in useable electric energy. The buildup of converter stations, export cables, grid connections, onshore transmission systems is inefficient and very expensive, for example due to the material-intensive cabling requiring e.g., large amounts of copper, aluminum, and even sea cable arming.

It has now been surprisingly found that it may be one possibility to overcome issues of the prior art (see discussion above) through saving several energy-conversion steps, thereby increasing an efficiency by more than 5%. In the proposed system, a renewable energy based DC generating unit and DC consumer are directly electrically connected to each other (at close proximity) and the system is self-contained. Hence, instead of transporting the low-commodity-value "electric energy" over long distances with high losses to a place of consumption, the high-commodity-value item "data" may be processed (computed) at close proximity of the site of a DC generation unit and be transported instead of electric energy itself, and without any losses. This may also lead to reducing investment costs as well as operations and maintenance cost. Public power grids may be relieved, and operation will be simplified.

In the following, exemplary embodiments of the component carrier will be described.

According to an exemplary embodiment, the system further comprises a DC source unit, in particular a storage battery, wherein the DC source unit directly connected to at least one of the DC generation unit and the DC consumer, and configured for storing and supplying DC. This may have the advantage that the DC consumer may be run uninterruptedly in the case that the DC generation unit ceases to work or needs more electric power than can be provided by the DC generation unit at that moment. Reasons for the DC generation unit ceasing to work may be a decrease in temporary availability of renewable energy, or e.g., a technical failure. The DC source unit may comprise a DC storage battery, but may also comprise a further DC generation unit, or a combination of both. The further DC generation unit may, in a preferred embodiment, also rely on renewable energy sources, but may in another embodiment rely on non-renewable energy sources, too. The DC source unit may be physically integrated with the DC consumer.

According to a further exemplary embodiment, the DC generation unit comprises one of a photovoltaic unit, a wind powered unit, a hydropower unit (e.g. a wave-and-tidal power unit), and the DC consumer comprises one of a data center, a server, a computer, a telecommunication system, a data microgrid, and an electrical circuit component. Combinations of different kinds of DC generation units and/or different kinds of DC consumers may be possible.

According to a further exemplary embodiment, the DC source unit and the DC consumer are connected in series and/or in parallel. The DC source unit may in particular be configured for being charged by the DC generation unit (and/or by the further DC generation unit). Therefore, the DC source unit may be continuously charged, up to the moment when it is needed to supply the DC consumer with electric power. Furthermore, in a case in which the DC generation unit produces more electric power than is needed by the DC consumer, this excessive power may be efficiently stored in the DC source unit. Hence, the DC source unit may further contribute to reducing the loss of usable energy. The DC source unit may be comprised by the DC

According to a further exemplary embodiment, the DC power circuit comprises a DC/DC converter for converting the DC from one voltage level to another. This may have the advantage that the system may be flexible and individually configurable with respect to the required voltage of the DC consumer. Furthermore, the system may be substantially independent from a DC (voltage) output of the DC generation unit. Optionally, the DC power circuit may also comprise protective switch gear.

According to a further exemplary embodiment, the DC consumer comprises at least one modular element, in particular at least one containerized element, further in particular at least one containerized data center, wherein the modular element is at least one of stackable, electrically and/or data-transmitting connectable with another modular element, and exchangeable. In the context of the present disclosure, the term "modular element" may in particular denote a structurally independent, self-contained element. In other embodiments, also the DC generation unit and/or the DC source unit may comprise one or more respective modular elements, which may also be stackable, electrically connectable with each other, and exchangeable.

In the context of the present disclosure, the term "stackable" may in particular denote that the respective modular elements' three-dimensional shapes match with each other. For example, the modular elements may have a similar footprint, similar main surfaces etc. Therefore, it may be possible to arrange modular elements vertically and/or horizontally next to each other in a space saving manner. In particular, the modular elements may also comprise (standardized) means to securely fix one modular element to another.

In the context of the present disclosure, the term "exchangeable" may particularly denote that a modular element may (in particular during use) be removed and/or replaced by another modular element, in particular without the need to shut the system or the DC consumer down. Hence, a modular element may be a standalone module which functions independently from other modular elements. However, the functional elements may be functionally connected to each other for e.g. combining computing capacity. An example would be a (standardized), in particular reinforced (i.e., higher in mechanical stability, as a weight of DC consumer devices contained therein may exceed standard operating limits of standard shipping containers), deep sea shipping container, for example one that is used for carrying freight on a container ship. The aforementioned features may have the technical effect that space may be saved, maintenance work may be carried out with respect to a single modular unit only, which may reduce down time, and the overall flexibility and efficiency of the system may be increased.

According to a further exemplary embodiment, the DC generation unit is isolated from a public power grid, and the DC consumer is connectable (only) to a data grid via a data connection. The data grid may be a public data grid, and/or a data grid connecting a plurality of systems according to embodiments of this disclosure. In other words, the DC generation unit may only produce electric power for the DC consumer it is directly connected to. Since the DC consumer may however be connected to a public data grid, electric power may be used without any loss on site, while data are exported (transmitted), which may be done substantially without any losses. Hence, the system may be a self-contained standalone system, (completely) independent from a public power grid. However, in other exemplary embodiments, the system, in particular the DC generation unit, may be connected to a public power grid. In that case, the DC consumer may still be exclusively powered by the DC generation unit only. Providing the system described herein as standalone system with respect to a public power grid, in particular if the system is an offshore wind turbine as will be described with respect to further embodiments below, may further underline the overall benefit of the present invention. Transmission of electricity via a (subsea) power cable is very expensive due to i) transmission losses and ii) material cost of the cables and the power grid itself. However, if the system is isolated from a power grid and only data are exported, according to exemplary embodiments, the transmission means would only be a data line instead, e.g., a fiber optic cable. Such a data line (data connection) is much more cost effective than an electric power line. Hence, it may be a technical effect of embodiments of the present invention that material (amount and cost) may be significantly reduced, compared to the prior art.

According to a further exemplary embodiment, the data connection is configured for sending and receiving data, and the data connection comprises at least one of a wireless data connection means and a data cable, in particular a glass fiber data cable. Hence, data may be efficiently transmitted to or from a (public) data grid. The data connection, in particular the wireless data connection, may also be configured and used for communication, e.g., between the DC consumer and the DC generation unit, and/or between different ones of the modular elements comprised by the DC consumer. A DC source unit may be physically integrated with a modular element of the DC consumer, i.e. each modular element may comprise its own DC source unit.

According to a further exemplary embodiment, the DC consumer further comprises a carbon-footprint token-generator, configured for generating a carbon-footprint token, in particular for being integrated into a Guarantee-of-Origin database. This ma, for example, be a centralized, proprietary Guarantee-of-Origin data base. In the context of the present disclosure, the term "carbon-footprint token-generator" may particularly refer to a hardware component and/or to program components, configured for generating a "carbon-footprint token". A carbon-footprint token may serve as Guarantee of Origin (GoO), proving that the data were computed using renewable energy based power and/or energy and/or other environmental attributes. Conventionally, a GoO in electricity is lost once the power has been consumed. According to this exemplary embodiment, a GoO is conserved and therefore, generating a carbon-footprint token has the technical effect that the use of renewable energy and/or energy and/or other environmental attributes may be traced substantially unlimitedly.

According to a further exemplary embodiment, the DC consumer is configured for computing a blockchain, in particular configured for cryptocurrency mining, and in particular, the carbon-footprint token-generator is further configured for generating the carbon-footprint token for being integrated into a block of the blockchain. A blockchain is a growing list of records, called blocks, that are linked together using cryptography. It is a decentralized peer-to-peer immutable data storage, that is spread over a network of participants (so called "nodes"). Each block may contain a cryptographic hash of a previous block, a timestamp, transaction data, and further information. As blocks each contain information about the block previous to it, they form a chain, with each additional block reinforcing the ones before it. Blockchain is considered a very secure technology with respect to data safety. Many cryptocurrencies are based on blockchain, for example Bitcoin. However, in particular due to its decentralized build-up, it is a technology with high energy consumption. Conventionally, a high energy consumption means high energy losses in absolute terms. Directly connecting a DC consumer which is configured for blockchain computing to a renewable energy based DC generation unit may have the benefit that energy losses may be kept at a very low level while data can be economically and ecologically processed. Since the system described herein may be a standalone system, the decentralization of the blockchain computing may be promoted. Furthermore, if the carbon-footprint token-generator is configured for generating the carbon-footprint token for being integrated into a block of the blockchain, the GoO is securely conserved and therefore, this has the technical effect that the use of renewable energy and/or energy and/or other environmental attributes may be traced substantially over the entire blockchain.

According to a further exemplary embodiment, the system is a wind turbine and further comprises a support structure, and the DC generation unit comprises a wind turbine generator, in particular a direct drive wind turbine generator. Further in particular, the wind turbine may be an offshore wind turbine. Offshore wind turbines according to embodiments may be floating and/or seabed mounted.

According to a further exemplary embodiment, the support structure comprises a wind turbine tower and a platform, mounted to the wind turbine tower and configured for accommodating or carrying the DC consumer, in particular above sea level. Providing a platform may have the further advantage that the components of the system, i.e., the DC consumer, the DC source unit, and other components, are easily accessible and exchangeable, while the dimensions of wind turbine tower do not have to be adjusted to accommodate those components. The system may, in further embodiments, also comprise emergency switches and electrical safety and protection facilities, and fire detection and extinction facilities.

According to yet a further embodiment of the invention the system further comprises a cooling means, wherein the cooling means is thermally coupled to the DC consumer, and wherein the cooling means is configured for using (sea or fresh) water to cool the DC consumer. In particular, the cooling means is directly electrically connected to the DC generation unit and/or to the DC source unit. This may have the technical effect that cooling of the DC consumer may also be based on renewable energies. Furthermore, in the case of an offshore wind turbine, sea water may be used to cool the DC consumer. Sea water is readily available and may be returned to the sea after cooling the DC consumer. Cooling may be carried out without the use of any coolants or chemicals. In combination with the use of electric power from the DC generation unit (or DC source unit), even cooling of the DC consumer may be eco-friendly. It will be apparent to the skilled person that if the system is land based, fresh water e.g., from a river or a lake may be used instead of sea water. The cooling means may comprise a (sea) water filter or treatment device, a heat exchanger, and a circulation pump.

It has to be noted that embodiments of the invention have been described with reference to different subject matters. In particular, some embodiments have been described with reference to apparatus type claims whereas other embodiments have been described with reference to method type claims. However, a person skilled in the art will gather from the above and the following description that, unless indicated otherwise, in addition to any combination of features belonging to one type of subject matter also any combination of features relating to different subject matters, in particular of features of the method type claims and features of the apparatus type claims, is considered disclosed with this document.

The aspects defined above, and further aspects of the present invention are apparent from the examples of embodiments to be described hereinafter and are explained with reference to the examples of embodiments. The invention will be described in more detail hereinafter with reference to examples of embodiments, to which the invention is, however, not limited.

### Brief Description of the Drawings

Figure 1 shows a system comprising a DC generation unit and a DC consumer, according to exemplary embodiments of the invention.
Figure 2 shows system, wherein the DC consumer comprises a plurality of modular elements, according to exemplary embodiments of the invention.
Figure 3 shows a server farm, according to exemplary embodiments of the invention.
Figure 4 shows an offshore wind turbine according to exemplary embodiments of the invention.
Figure 5 shows a carbon-footprint token-generator, according to exemplary embodiments of the invention.
Figure 6 shows a system according to further exemplary embodiments of the invention.
Figure 7 shows an offshore wind turbine comprising a system according to exemplary embodiments of the invention.

### Detailed Description of Exemplary Embodiments

The illustration in the drawings is schematic. It is noted that in different figures, similar or identical elements or features are provided with the same reference signs. In order to avoid unnecessary repetitions elements or features, which have already been elucidated with respect to a previously described embodiment are not elucidated again at a later position of the description.

Furthermore, spatially relative terms, such as "front" and "back", "above" and "below", "left" and "right", et cetera are used to describe an element's relationship to another element(s) as illustrated in the figures. Thus, the spatially relative terms may apply to orientations in use which differ from the orientation depicted in the figures. Obviously, all such spatially relative terms refer to the orientation shown in the figures only for ease of description and are not necessarily limiting, as an apparatus according to an embodiment of the invention can assume orientations different than those illustrated in the figures when in use.

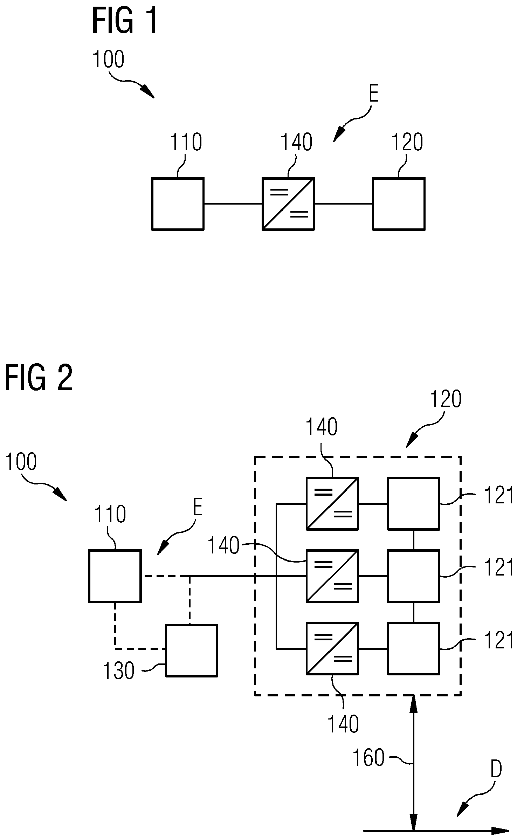

**Figure 1** shows a system 100 comprising a renewable energy based direct current DC generation unit 110 configured for outputting DC, a DC consumer 120, configured for computing and storing data and for being powered by DC, and a DC power circuit E. The DC generation unit 110 and the DC consumer 120 are directly electrically connected with each other via the DC power circuit E. The DC power circuit further comprises a DC/DC converter 140 for converting the DC from one voltage level to another. The DC generation unit 110 may for example comprise a photovoltaic unit, and the DC consumer 120 may comprise a server and a computer.

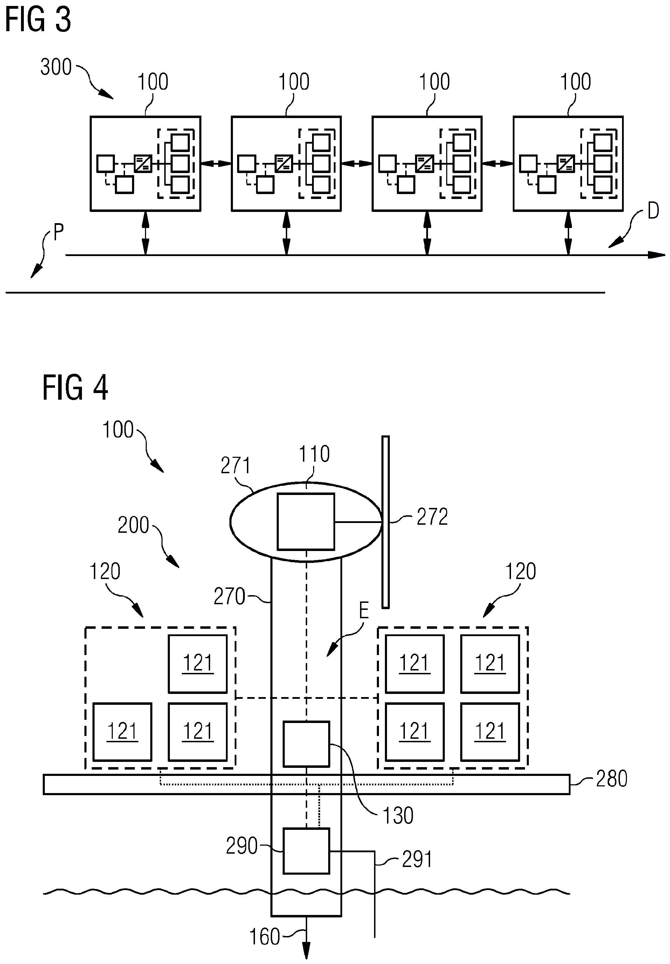

**Figure 2** illustrates a further exemplary embodiment of the system which is shown in Figure 1. However, in addition, the system 100 further comprises a DC source unit 130, which may be a storage battery. The DC source unit 130 is (directly) connected, via the system's DC power circuit E, to both the DC generation unit 110 and the DC consumer 120 and is configured for storing DC, e.g., generated by the DC generation unit 110, and for supplying DC to the DC consumer 120. The DC source unit 130 and the DC consumer 120 are connected in series or in parallel, which is symbolized by the dotted lines in the DC power circuit E. As can be taken from Figure 2, the DC consumer 120 comprises three modular elements 121. Those may, for example be containerized data centers, e.g., data centers packed into shipping containers. The modular elements 121 are electrically connected to each other. This may include an electric power connection, but also a data link or connection. The DC consumer 120 is connected to a data grid D via a data connection 160. Hence, the system 100 depicted in Figure 3 is configured for sending and receiving data. The data connection 160 comprises for example a data cable 160, in particular a glass fiber data cable, which is connected to the data grid D. The DC consumer further comprises three DC/DC converters 140: one for each modular element 121. Hence, each modular element 121 may be supplied with electricity of a different voltage. There may in some embodiments also be DC/DC converters 140 comprised in the DC power circuit E directly connecting the DC generation unit 110 and the DC source 130, i.e. connected between the DC generation unit 110 and the DC source 130.

**Figure 3** shows a server farm 300, comprising a plurality of systems 100 according to exemplary embodiments of the present disclosure. Each system 100, in particular the respective DC generation units 110, are isolated from a public power grid P, but connected to a data grid D. Thus, the systems 100 are standalone systems 100 with regard to a public power grid P. However, the respective systems 100 may be electrically connected to each other. Hence, if one system 100 has, for example, a higher than usual demand for electric power, this excessive amount of electric power may be supplied by another one of the systems 100. Likewise, if the DC consumers 120 are for example data centers, and one system needs additional computing power, it may be possible to use another system's data center's 120 computing power. The systems 100 may therefore also be data linked to each other. In another embodiment, the server farm 300 may work according to the master and slave principle. The master and slave principle is a model for a communication protocol in which one device or system (the master) controls one or more other devices or systems (the slaves). In a standard Modbus network, there may be one master and up to 31 slaves.

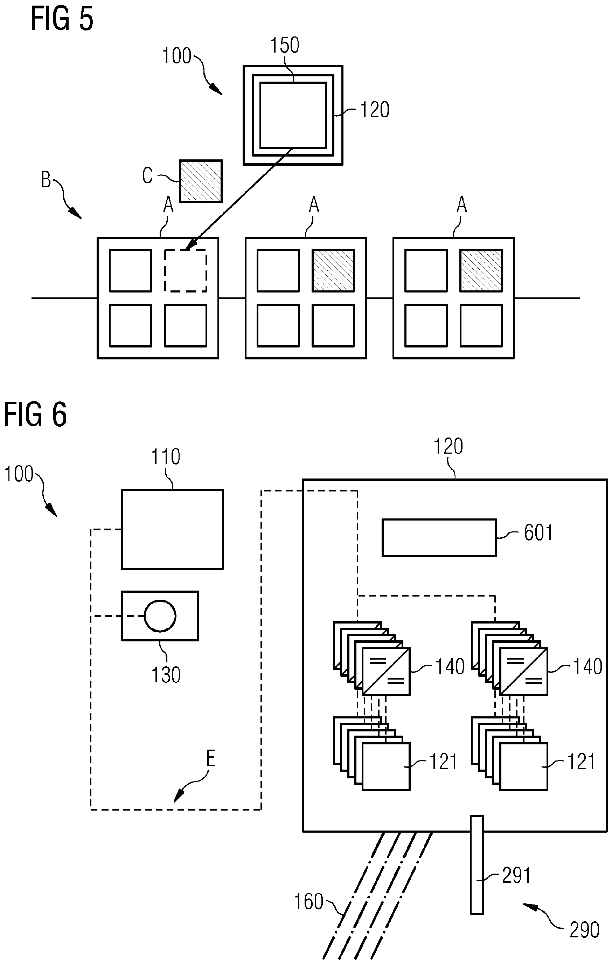

**Figure 4** shows an exemplary embodiment of the present disclosure in which the system 100 is an offshore wind turbine and further comprises a support structure 200, which comprises a wind turbine tower 270, and a platform 280. The platform 280 is mounted to the wind turbine tower 270 and configured for accommodating or carrying the DC consumer 120 above sea level. The support structure 200 further comprises a nacelle 271 for housing the DC generation unit 110, which comprises a wind turbine generator driven by a rotor 272. The system 100 further comprises a cooling means 290, which thermally coupled to the DC consumer 120 (represented by dotted line. The cooling means 290 is further configured for using sea water to cool the DC consumer 120 and is directly electrically connected to the DC generation unit 110 and to the DC source unit 130. Sea water can be supplied and recycled via a cooling water conduit 291 (a pipe or a similar means). From Figure 4, it can further be taken that the modular elements 121 are stackable and exchangeable. The operation of the system 100 may be described as follows. Energy, e.g. kinetic energy stored in the wind, drives the rotor 272, which is coupled to the wind turbine generator. In a preferred embodiment, the wind turbine generator is a direct drive generator. A direct drive generator may be driven by a driving element (such as the rotor 272) without the need for any gearbox between the driving element and the direct drive generator. In other words, the driving element may be directly connected to the direct drive generator via a shaft. This contributes to eliminating gearbox failure and transmission losses. In consequence, a direct drive wind turbine's direct drive generator speed is equivalent to the rotor speed. Still referring to Figure 4, the DC generation unit 110 outputs DC, which may or may not be transformed or converted by a DC/DC converter (not shown in Figure 3). The DC is used to i) charge the DC source unit 130 and ii) to power the DC consumer 120 via the direct electric connection through the DC power circuit E. The DC is further used to power the cooling means 290, which uses sea water and cools the DC consumer 120 via a thermal connection (e.g., pipes and a heat exchanger). The DC consumer 120 computes data in its mutually connected modular elements 121. The data are then exported via a data connection 160. Carbon-footprint tokens comprised by the data may, according to a further embodiment of this disclosure, prove that the DC consumer 120 is powered by renewable energy. This will be apparent from Figure 5.

Now referring to **Figure 5****,** there is shown an exemplary embodiment of the present disclosure, wherein the DC consumer 120 is configured for computing a blockchain B. The system 100 comprises the DC consumer 120, which further comprises a carbon-footprint token-generator 150, configured for generating a carbon-footprint token C for being integrated into a block A of the blockchain B. Since each block A of the blockchain B comprises a carbon-footprint token C, the traceability of the use of renewable energy may be ensured.

**Figure 6** shows a system 100 according to a further embodiment of the present disclosure. The depicted system 100 is similar to the ones described before, however it is not a wind turbine. In addition to what has already been described, the DC consumer 120 further comprises a "high performance data center pilot" (HPDCP) 601 A HPDCP may be a unit consisting of hardware and software using sensors, parameters, variables, forecast data. E.g., the HPDCP may take into account a (forecast) renewable resource availability (e.g., a (forecast) wind speed and turbulences), the respective status of DC generation unit 110 and DC source unit 130 (e.g. an availability), the respective status of the DC consumer 121 and/or its modular elements 121 (e.g., an availability, an actual capacity, a forecasted capacity), actual and/or forecast computing and data storing tasks performed by the DC consumer 120, an actual and/or forecast data transmission capacity level, while also taking into consideration a server farm layout 300 and a status of the respective units 100 to maximize utilization of the server farm 300 and/or to anticipate operational constraints (e.g., prepare a battery storage of the DC source unit for a low wind period, hibernate some modular elements 121 and/or whole systems 100, ramp up modular elements 121 and/or whole systems 100, and/or prepare for service/maintenance/repair of systems 100 and its components). A HPDCP may therefore comprise an interface between a system 100 and other systems 100 (e.g., as in a server farm 300 as shown in and described with reference to Figure 3) and for example a connection to a data grid D. Furthermore, the DC consumer 120 as shown in Figure 6 comprises, in parallel, two batteries of respective pluralities of modular elements 121, each having a DC/DC converter 140 connected upstream.

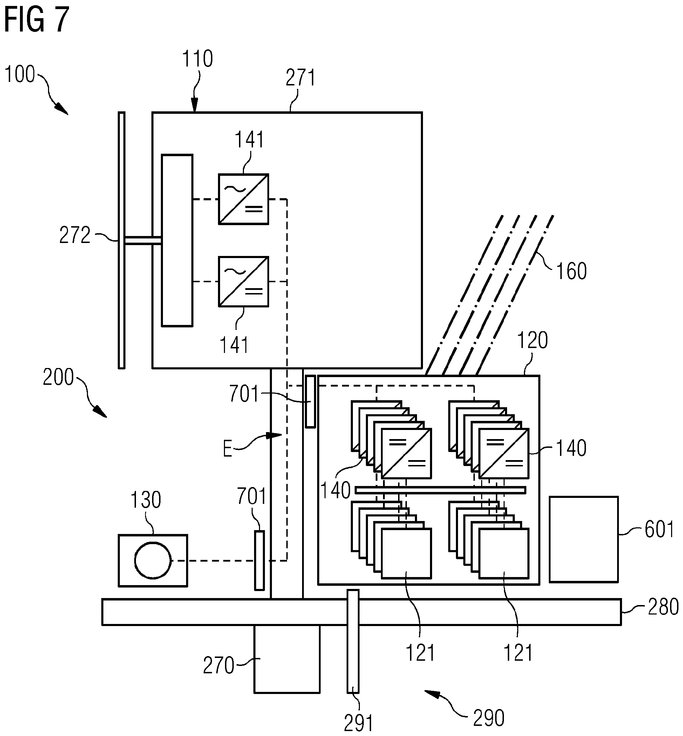

**Figure 7** shows in principle the same system 100 as has been described in detail with respect to Figure 4, i.e. an (offshore) wind turbine. In addition, the system 100 further comprises a HPDCP 601. Furthermore, as is shown in the nacelle 271, the DC generation unit 110 comprises two AC/DC converters 141, which may according to some embodiments be necessary, depending on the type of renewable energy based DC generation unit used. Hence, the DC generation unit 110 is configured for outputting a DC. However, although conversion losses have been described before, the embodiment described herein still has all the benefits of other embodiments without any AC/DC conversion stage. In a conventional setup as is known from the state of the art, in order to be able to transport the generated electric power over long distances, at least two more additional conversion stages would be required (at least one more DC/AC converter and one more AC/DC converter). Hence, losses may still be kept at a very low level in the embodiment shown in Figure 7 when compared to the prior art. Referring again to Figure 7, there are also shown standardized connection points 701 configured for connecting the DC source unit 130 and the DC consumer 120 to the electric power grid E of the system 100. "Standardized connection points" may, in the context of this document, particularly denote connection devices, which are interchangeable across all DC consumers 120 in one system 100 and/or in a server farm 300 and which comprise integrated connection means for cooling, energy supply, data connection, and peripherals (such as protective equipment for fire/lightening protection, etc.).
It should be noted that the term "comprising" does not exclude other elements or steps and the use of articles "a" or "an" does not exclude a plurality. Also, elements described in association with different embodiments may be combined. It should also be noted that reference signs in the claims should not be construed as limiting the scope of the claims.

## Claims

1. A system (100) comprising
a renewable energy based direct current (DC) generation unit (110) configured for outputting DC,
a DC consumer (120), configured for computing and storing data and for being powered by DC, and
a DC power circuit (E);
wherein the DC generation unit (110) and the DC consumer (120) are directly electrically connected with each other via the DC power circuit (E).

2. The system (100) according to the preceding claim, further comprising
a DC source unit (130), in particular a storage battery, directly connected to at least one of the DC generation unit (110) and the DC consumer (120) and configured for storing and supplying DC.

3. The system (100) according to one of the preceding claims,
wherein the DC generation unit (110) comprises one of a photovoltaic unit, a wind powered unit, a hydropower unit;
wherein the DC consumer (120) comprises one of a data center, a server, a computer, a telecommunication system, a data microgrid, and an electrical circuit component.

4. The system (100) according to one of the preceding claims, wherein the DC source unit (130) and the DC consumer (120) are connected in series or in parallel.

5. The system (100) according to one of the preceding claims, wherein the DC power circuit (E) comprises a DC/DC converter (140) for converting the DC from one voltage level to another.

6. The system (100) according to one of the preceding claims,
wherein the DC consumer (120) comprises at least one modular element (121), in particular at least one containerized element, further in particular at least one containerized data center,
wherein the modular elements (121) are at least one of stackable, electrically and/or data-transmitting connectable to another modular element, and exchangeable.

7. The system (100) according to one of the preceding claims, wherein, the DC generation unit (110) is isolated from a public power grid (P), and wherein the DC consumer (120) is connectable to a data grid (D) via a data connection (160).

8. The system (100) according to the preceding claim,
wherein the data connection (160) is configured for sending and receiving data, and
wherein the data connection (160) comprises at least one of a wireless data connection means and a data cable, in particular a glass fiber data cable.

9. The system (100) according to any of the preceding claims, wherein the DC consumer (120) further comprises a carbon-footprint token-generator (150), configured for generating a carbon-footprint token (C), in particular for being integrated in to a Guarantee-of-Origin database.

10. The system (100) according to the preceding claim, wherein the DC consumer (120) is configured for computing a blockchain (B), in particular configured for cryptocurrency mining, and
wherein, in particular, the carbon-footprint token-generator (150) is further configured for generating the carbon-footprint token (C) for being integrated into a block (A) of the blockchain (B).

11. The system (100) according to any of the preceding claims,
wherein the system (100) is a wind turbine and further comprises a support structure (200), and
wherein the DC generation unit (110) comprises a wind turbine generator, in particular a direct drive wind turbine generator.

12. The system (100) according to the preceding claim,
wherein the support structure (200) comprises a wind turbine tower (270), and
a platform (280), mounted to the wind turbine tower (270) and configured for accommodating or carrying the DC consumer (120), in particular above sea level.

13. The system (100) according to one of the preceding claims, further comprising
a cooling means (290),
wherein the cooling means (290) is thermally coupled to the DC consumer (120) and
wherein the cooling means (290) is configured for using water, in particular sea water, to cool the DC consumer (120), and
wherein, in particular, the cooling means (290) is directly electrically connected to the DC generation unit (110) and/or to the DC source unit (130).

14. A server farm (300), comprising a plurality of systems (100) according to any of the claims 1 to 13.

15. A method of using a system (100) according to any of the claims 1 to 13 for computing and storing data.
